# EUROPÄISCHE PATENTSCHRIFT

(11) **EP 2 817 259 B1**
(45) Veröffentlichungstag und Bekanntmachung des Hinweises auf die Patenterteilung: **13.06.2018**
(21) Anmeldenummer: 13704076.2
(22) Anmeldetag: 08.02.2013
(51) Int. Cl.: B81C 99/00

(54) **VERFAHREN ZUR HERSTELLUNG EINES SENSORS**
METHOD FOR PRODUCING A SENSOR
PROCÉDÉ DE FABRICATION D'UN CAPTEUR

(30) Priorität: 24.02.2012 DE 102012101505
(43) Veröffentlichungstag der Anmeldung: 31.12.2014
(73) Patentinhaber: TDK Corporation, Tokyo 108-0023 (JP)
(72) Erfinder: PAHL, Wolfgang, 81379 München (DE); LEIDL, Anton, 85662 Hohenbrunn (DE); PORTMANN, Jürgen, 81677 München (DE); EICHINGER, Robert, 82069 Hohenschäftlarn (DE); SIEGEL, Christian, 83104 Tuntenhausen (DE); NICOLAUS, Karl, 85604 Zorneding (DE); WASSNER, Thomas, 81925 München (DE); SEDLMEIER, Thomas, 85276 Pfaffenhofen an der Ilm (DE)
(74) Vertreter: Epping - Hermann - Fischer
(86) Internationale Anmeldenummer: PCT/EP2013/052553
(87) Internationale Veröffentlichungsnummer: WO 2013/124170

(56) Entgegenhaltungen:
- WO-A1-2012/004339

## Beschreibung

Die vorliegende Erfindung betrifft ein Verfahren zur Herstellung eines Sensors.
Insbesondere betrifft die Erfindung ein Verfahren zur Herstellung eines MEMS-Mikrofons, bei dem ein Wandlerelement zwischen einem Träger und einer Abdeckung eingeschlossen ist. Das Wandlerelement kann akustische Signale, die durch eine Schalleintrittsöffnung eintreten, in elektrische Signale umwandeln.
Oftmals werden an die Sensitivität eines Sensors Anforderungen gestellt, die eine Öffnung des Sensors an einer bestimmten Stelle verlangen. Beispielsweise kann bei einem MEMS-Mikrofon eine bestimmte Akustik gewünscht sein, zu deren Erreichung die Schalleintrittsöffnung an einer bestimmten Stelle angeordnet werden muss. Diese Anforderung führt zu einer aufwendigen Fertigung und komplizierten Funktionstests. WO 2012/004339 zeigt eine typische Funktionstest für einen MEMS-Sensor. Der hergestellte Sensor hat eine Öffnung in der Gehäusedeckschicht, aber ein Schalltest wird durch ein temporäres Loch in dem Gehäusesubstrat durchgeführt.

US 2009/0230487, lehrt in Figur 5 ein Verfahren wo eine Anordnung von MEMS Sensorverpackungen mit Durchgangsöffnungen in den Deckeln auf ein Trägerfolie zum vereinzeln angeordnet sind.

Aufgabe der vorliegenden Erfindung ist es daher, ein Verfahren zur Herstellung eines Sensors anzugeben, das die Erzeugung einer Öffnung in dem Sensor in einfacher Weise ermöglicht.
Diese Aufgabe wird durch ein Verfahren gemäß dem Anspruch 1 gelöst. Vorteilhafte Ausgestaltungen sind den weiteren Ansprüchen zu entnehmen.
Es wird ein Verfahren zur Herstellung eines Sensors vorgeschlagen, das die folgenden Schritte aufweist:
- Anordnen eines Sensorelements auf einen Träger,
- Anordnen einer Abdeckung auf dem Sensorelement, wobei das Sensorelement zwischen der Abdeckung und dem Träger eingeschlossen wird,
- Aufkleben einer Trägerfolie auf die Abdeckung, und
- Erzeugen einer Öffnung in der Trägerfolie und der Abdeckung, wobei die Öffnungen in der Trägerfolie und der Abdeckung zumindest teilweise überlappen,
- Entfernen der Trägerfolie vom Sensor.
Als Öffnung wird hier ein Durchbruch im Gehäuse oder in der Abdeckung des Sensors bezeichnet, durch den das ansonsten verkapselte Sensorelement mit der Umgebung kommuniziert. Je nach zugrundeliegendem Sensortyp wird ein entsprechender Zugang geschaffen, beispielsweise für Schallwellen im Falle eines Mikrofons, für Luftdruck im Falle eines Drucksensors oder Luftaustausch im Falle von Sensoren für Luftfeuchte, Sensoren zur Bestimmung von Gaszusammensetzungen oder Sensoren zur Bestimmung biochemischer Parameter.
Die Abdeckung des Sensors kann sich aus mehreren Schichten zusammensetzen. Beispielsweise kann die Abdeckung durch eine Abdeckfolie aus Kunststoff gebildet werden. Ferner kann die Abdeckung eine Metallisierungsschicht, beispielsweise eine Grundmetallisierung und eine Verstärkungsschicht, aufweisen.
Das Aufkleben des Sensors auf der Trägerfolie ermöglicht es, über die Öffnungen in der Trägerfolie und der Abdeckung eine Ansteuerung des Sensorelementes vorzunehmen. Beispielsweise kann für einen Funktionstest eines Mikrofons über diese Öffnung Schall zugeführt werden. Ferner kann durch eine Bewegung der Trägerfolie der Sensor bewegt werden.

Dementsprechend kann es die Trägerfolie ermöglichen, den Sensor einer Testapparatur zuzuführen.

In einem Ausführungsbeispiel wird die Öffnung in der Trägerfolie und der Abdeckung nach dem Aufkleben der Trägerfolie erzeugt. Insbesondere können die Öffnungen der Trägerfolie und in der Abdeckung in einem gemeinsamen Verfahrensschritt erzeugt werden. Beispielsweise kann die Öffnung in der Trägerfolie und in der Abdeckung durch Bohren, insbesondere Laserbohren erzeugt werden. Nach dem Erzeugen der Öffnung muss der Sensor nicht auf eine andere Folie umgeklebt werden, stattdessen kann die gesamte Trägerfolie verschoben werden.

Dementsprechend zeichnet sich das Verfahren durch eine besonders einfache Handhabung der Sensoren auf engem Raum unter geringem Verbrauch von Hilfsmaterialien aus.

In einem Ausführungsbeispiel sind die Öffnungen der Trägerfolie und der Abdeckung deckungsgleich. Deckungsgleiche Öffnungen ergeben sich insbesondere dann, wenn die Öffnung in der Trägerfolie und in der Abdeckung in einem gemeinsamen Verfahrensschritt, z. B. durch Laserbohren, erzeugt werden.

In einem alternativen Verfahren wird je eine Öffnung in der Trägerfolie und in der Abdeckung vor dem Aufkleben der Trägerfolie erzeugt. Ferner wird dabei das Sensorelement beim Aufkleben derart positioniert, dass sich die Öffnungen der Trägerfolie und der Abdeckung zumindest teilweise überlappen.

Die Sensoren werden somit mit bereits vorhandenen Öffnungen auf eine vorperforierte Trägerfolie aufgesetzt. Es ist beispielsweise denkbar, dass die Sensoren produziert werden und eine Öffnung erzeugt wird, anschließend die Sensoren jedoch über längere Zeit unbenutzt gelagert werden. Zu einem späteren Zeitpunkt soll die Funktionsfähigkeit der Sensoren überprüft werden. Nunmehr werden die Sensoren auf eine Trägerfolie aufgeklebt, die bereits mit Öffnungen vorperforiert ist. Auf diese Weise kann die Trägerfolie benutzt werden, um die Sensorelemente einer Testapparatur zuzuführen.

Vorzugsweise werden bei dem Verfahren eine Vielzahl von Sensorelementen auf einem Trägersubstrat angeordnet und eine Abdeckung derart auf dem Sensorelement angeordnet, dass die Sensorelemente jeweils zwischen dem Trägersubstrat und der Abdeckung eingeschlossen werden. Ferner kann eine Trägerfolie auf die Abdeckung geklebt werden und die Sensorelemente können nach dem Aufkleben der Trägerfolie vereinzelt werden.

Dieses Verfahren ermöglicht es, eine aufwendige Handhabung einzelner Bauelemente zu vermeiden. Stattdessen wird ein gemeinsames Trägersubstrat, das beispielsweise einige tausend Bauelemente aufweisen kann, über eine große Zahl von Fertigungsschritten im unmittelbaren Verbund behandelt. Der unmittelbare Verbund der Sensorelemente zeichnet sich dadurch aus, dass die Sensorelemente fest miteinander verbunden sind, etwa weil sie auf einem gemeinsamen Trägersubstrat angeordnet sind.

Nach dem Aufkleben auf der Trägerfolie und dem Vereinzeln können die Sensoren über die Trägerfolie weiterhin im mittelbaren Verbund zueinander gehalten werden, so dass auch nach der Vereinzelung Verfahrensschritte durchgeführt werden können, bei denen eine Vielzahl von Sensoren gleichzeitig behandelt wird. Insbesondere die Erstellung der Sensoröffnung und die Funktionsprüfung der Sensoren kann im mittelbaren Verbund durchgeführt werden, wobei durch das Aufkleben auf die Trägerfolie die einzelnen Sensoren relativ zueinander ausgerichtet bleiben.
Der mittelbare Verbund der Sensorelemente zeichnet sich dadurch aus, dass die Sensorelemente auf einer gemeinsamen Trägerfolie angeordnet sind und sich somit nicht völlig frei bewegen können. Allerdings sind die Sensorelemente nicht so starr aufeinander ausgerichtet wie im unmittelbaren Verbund. Es sind beispielsweise kleinere Verschiebungen einzelner Sensorelemente möglich.
Durch die Behandlung einer Vielzahl von Sensoren gemeinsam im mittelbaren Verbund in den Verfahrensschritten "Erzeugen der Öffnung" und "Funktionstest" können die Herstellungskosten erheblich gesenkt werden. Bei der Vereinzelung, bei der die Sensoren auf der Trägerfolie aufgeklebt bleiben, können die Sensoren möglicherweise geringfügig verschoben werden. Diese Verschiebung kann jedoch durch ein Detektionsverfahren erkannt und somit ausgeglichen werden. Als Detektionsverfahren eignet sich hier insbesondere eine automatische Bilderkennung. Im letzten Verfahrensschritt können die Sensoren von der Trägerfolie mittels eines Bestückers abgenommen werden und unmittelbar an ihren Bestimmungsort, beispielsweise auf eine Leiterplatte oder in eine Verpackung, abgelegt werden.
Die Trägerfolie übernimmt während des Herstellungsverfahrens wichtige Aufgaben, wie etwa die einzelnen Sensoren im mittelbaren Verbund zueinander ausgerichtet zu halten. Ferner kann die Trägerfolie als Dichtvorrichtung zwischen dem Sensor und einer Testapparatur dienen. Oftmals weist eine Testapparatur für Sensoren ein Kopplungselement auf, das eine unmittelbare Verbindung zu dem Sensor herstellt. Die Testapparatur kann beispielsweise eine Ringwulst oder eine Ringscheide als Kopplungselement aufweisen. Um Beschädigungen des Sensors zu vermeiden und um eine möglichst luftdichte Kopplung zu erzielen, kann die Trägerfolie als Dichtung zwischen dem Kopplungselement und der Öffnung des Sensors eingesetzt werden. Dabei kann etwa das Kopplungselement der Testapparatur aus einem verschleißfreien Material gefertigt werden und der Verschleiß auf die nur temporäre Trägerfolie übertragen werden. Die Testapparatur kann beispielsweise eine Metall aufweisende Ringwulst oder eine Ringscheide als Kopplungselement aufweisen.

In einem Ausführungsbeispiel wird die Öffnung in der Trägerfolie und der Abdeckung durch Bohren erzeugt. Insbesondere kann die Öffnung durch Laserbohren erzeugt werden. Als Laser eignet sich besonders eine im UV arbeitende Quelle, z.B. mit einer Wellenlänge von 365 nm. Bei der Verwendung einer temporären Trägerfolie des UV-Release-Typs kann auch ein YAG-Laser, beispielsweise mit der Wellenlänge 1064 nm, oder ein CO₂-Laser mit Wellenlänge 10,6 µm eingesetzt werden.

In einem Ausführungsbeispiel weist die Abdeckung eine Schichtdicke auf, die im Bereich der zu erzeugenden Öffnung bereits beim Aufbringen der Abdeckung dünner ist als in einem anderen Bereich oder die in diesem Bereich nachträglich reduziert wird. Die Abdeckung im Bereich der zu erzeugenden Öffnung wird später in einem weiteren Verfahrensschritt wieder entfernt. Daher ist es vorteilhaft die Abdeckung in diesem Bereich dünner auszugestalten, um so das Entfernen der Abdeckung in diesem Bereich zu erleichtern.

Eine dünnere Ausgestaltung einer eine Metallschicht umfassenden Abdeckung in diesem Bereich kann beispielsweise mit Hilfe einer Resiststruktur erreicht werden.
Dementsprechend kann zunächst eine Grundmetallisierung über dem Sensorelement aufgebracht werden. Dann wird eine Resiststruktur im Bereich der zu erzeugenden Öffnung aufgebracht und eine metallische Verstärkungsschicht über der Grundmetallisierung erzeugt, wobei der von der Resiststruktur bedeckte Bereich der Grundmetallisierung frei von der Verstärkungsschicht bleibt. Anschließend kann die Resiststruktur entfernt werden. Alternativ verbleibt die Resiststruktur auf der Grundmetallisierung. Die Resiststruktur kann beispielsweise durch Drucken oder Jetten aufgebracht werden. In bevorzugtem Prozess wird die Resiststruktur durch Fotolithografie, beispielsweise durch Laserdirektbelichtung einer auflaminierten lichtempfindlichen Folie, erzeugt.

In einem Ausführungsbeispiel kann der dünnere Bereich der Abdeckung in einem Detektionsverfahren erkannt werden und zur Bestimmung der Position, an der die Öffnung erzeugt wird, benutzt werden. Insbesondere können die Resiststruktur oder die Kontur der erzeugten Dünnstelle in dem oben genannten Detektionsverfahren benutzt werden. Bei dem Detektionsverfahren kann es sich beispielsweise um eine automatische Bilderkennung handeln. Dabei werden die Resiststruktur bzw. die Kontur der Dünnstelle als Justiermarken verwendet und mittels dieser Justiermarken kann die Position der Sensoren errechnet werden. Anhand der in dieser Bilderkennung ermittelten Daten wird der Laser zur Erzeugung der Bohrung ausgerichtet. Ist die Resiststruktur bisher nicht entfernt worden, so wird sie durch das Bohren ganz oder teilweise entfernt.

Die Bilderkennung erfolgt hier durch die Trägerfolie hindurch. Daher ist es umso wichtiger, dass die Sensoren eine gut erkennbare Justiermarke aufweisen, da die Trägerfolie die Bilderkennung möglicherweise erschweren könnte.

Das hier beschriebene Verfahren eignet sich sowohl für Sensoren, die auf einer der Trägerfolie gegenüberliegenden Seite Mittel zur elektrischen Kontaktierung aufweisen, als auch für Sensoren, bei denen die Mittel zur elektrischen Kontaktierung auf der gleichen Seite wie die Trägerfolie angeordnet sind. Im zweiten Fall kann die Trägerfolie von den Mitteln zur elektrischen Kontaktierung oder von einer Kontaktiernadel einer Testapparatur durchbrochen und z.B. durchstochen werden oder in den Bereichen entfernt werden, in denen die Mittel zur elektrischen Kontaktierung angeordnet sind. Beispielsweise können die Mittel zur elektrischen Kontaktierung mit Hilfe eines Lasers freigelegt werden. Dementsprechend ist das Verfahren besonders vorteilhaft, da für eine Vielzahl verschiedener Sensoren ein einheitliches Herstellungsverfahren verwendet werden kann.

Bei dem Sensorelement kann es sich insbesondere um ein Wandlerelement handeln, das Schallwellen in elektrische Signale umwandelt. Dementsprechend ist der Sensor ein Mikrofon, insbesondere ein MEMS-Mikrofon.

Es kann sich bei dem Sensorelement jedoch auch um ein Drucksensorelement, ein Gassensorelement, ein Feuchtesensorelement oder ein biochemisches Sensorelement handeln.

Die Sensoröffnung kann mehrere kleinere Einzelöffnungen aufweisen. Dadurch kann beispielsweise ein effektiver Partikelschutz erreicht werden, da Partikel mit einem Durchmesser, der größer ist als der Durchmesser der Einzelöffnungen, nicht ins Innere des Sensors eindringen können. Mehrere Einzelöffnungen ermöglichen ferner auch eine gewünschte Richtcharakteristik oder einen Frequenzgang bei Mikrofonen einzustellen. Bei Differenzdrucksensoren sind getrennte Zuführungen über verschiedene Öffnungen möglich. Mehrere Einzelöffnungen ermöglichen bei Gas- und Feuchtesensoren eine verbesserte Medienspülung.

Das Vereinzeln kann im Prozessfluss an einer beliebigen Stufe vorgenommen werden. Vorteilhaft wird es jedoch vorzugsweise vor der Funktionsprüfung durchgeführt, um dann Fehler im Trennprozess, d.h. beim Vereinzeln, in der Funktionsprüfung erkennen zu können. Wird das Vereinzeln vor dem Bohren einer Öffnung durchgeführt, so kann verhindert werden, dass Sägeflüssigkeit oder Staub in den Innenraum des Sensors eindringt.

Im Folgenden wird die Erfindung anhand von Ausführungsbeispielen und den dazugehörigen Figuren näher erläutert. Die Figuren sind dabei nur schematisch und nicht maßstabsgetreu ausgeführt, so dass den Figuren weder absolute noch relative Maßangaben entnehmbar sind.
Figuren 1A bis 1G zeigen verschiedene Verfahrensstufen bei der Herstellung eines Sensors und
Figur 2 zeigt einen Funktionstest einer Vielzahl von Sensoren.

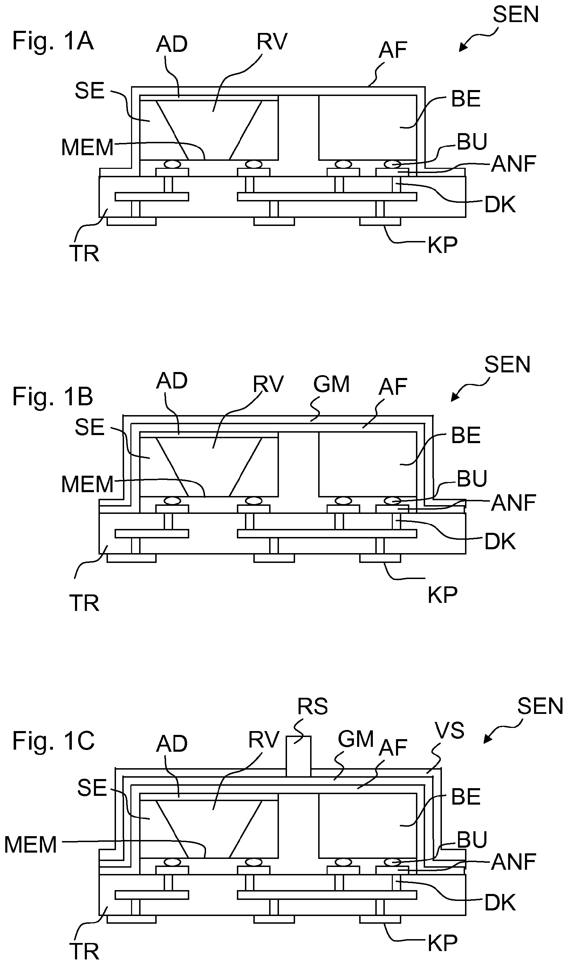

Die Figuren 1A bis 1G zeigen verschiedene Verfahrensstufen der Herstellung eines Sensors SEN. Figur 1A zeigt einen Sensor SEN nach der Montage eines Sensorelementes SE und eines optionalen weiteren Bauelementes BE auf einem Träger TR. Das in den Figuren 1A bis 1F gezeigte Verfahren eignet sich auch zur Herstellung von Sensoren SEN eines beliebigen Sensortyps, beispielsweise für Sensoren zur Druckmessung, Sensoren zur Messung der Luftfeuchte, Sensoren zur Bestimmung von Gaszusammensetzungen oder anderen biochemischen Parametern.

In dem hier gezeigten Beispiel handelt es sich bei dem Sensor SEN um ein MEMS-Mikrofon. Das Sensorelement SE ist ein Wandlerelement, das Schallwellen in elektrische Signale umwandelt. Das Wandlerelement weist eine Membran MEM und ein Rückvolumen RV auf. Das Rückvolumen RV wird von einer ersten Abdeckung AD begrenzt, die auf Waferlevel aufgebracht wird. Bei der ersten Abdeckung AD handelt es sich um eine Folie.

Eine Abdeckfolie AF ist über dem Sensorelement SE und dem weiteren Bauelement BE aufgebracht, wobei die Abdeckfolie AF mit dem Träger TR seitlich rundum abschließend abdichtet. Die Abdeckfolie AF kann beispielsweise Kunststoff aufweisen.

Das Sensorelement SE ist über Bumps BU elektrisch mit dem Träger TR kontaktiert. Der Träger TR weist auf seiner dem Sensorelement SE zugewandten Seite Anschlussflächen ANF auf. Auf der dem Sensorelement SE abgewandte Seite weist der Träger TR Kontaktpads KP auf. Die Kontaktpads KP und die Anschlussflächen ANF sind über Durchkontaktierungen DK miteinander verbunden. Die Kontaktpads KP dienen zur elektrischen Kontaktierung des Sensors SEN. Es sind auch Ausgestaltungen denkbar, bei denen die Kontaktpads KP zur elektrischen Kontaktierung auf der gleichen Seite des Trägers TR angeordnet sind wie das Sensorelement SE und das weitere Bauelement BE.

Auch das weitere Bauelement BE ist in Flip-Chip-Technik mittels Bumps BU auf dem Träger TR montiert. Bei dem weiteren Bauelement BE kann es sich beispielsweise um ein Schaltungselement handeln, das die vom Sensorelement SE aufgenommenen Daten weiterverarbeitet und auswertet.

Figur 1B zeigt den Sensor SEN nach einem weiteren Verfahrensschritt. Auf der Abdeckfolie AF ist eine Grundmetallisierung GM ganzflächig aufgebracht, beispielsweise durch Plasmaabscheidung oder durch Sputtern. Dazu wird ein Metall wie z.B. Ti oder eine Mischung oder eine Schichtfolge von Metallen verwendet, die zum einen gute Haftung auf der Abdeckfolie AF gewährleisten und zum andern gut als Wachstumsschicht zum späteren galvanischen Verstärken der Grundmetallisierung GM geeignet sind.

Figur 1C zeigt den Sensor SEN nach dem nächsten Schritt. Die Grundmetallisierung GM wird galvanisch verstärkt. Vorzugsweise wird die Verstärkung derart vorgenommen, dass eine Öffnung SO vorgebildet wird z.B. indem eine für eine Öffnung SO vorgesehene Fläche von der galvanischen Verstärkung ausgenommen wird. Dazu kann eine Resiststruktur RS im Bereich der späteren Öffnung SO auf der Grundmetallisierung GM erzeugt werden, beispielsweise durch Strukturierung einer Fotolackschicht. Bei der Öffnung SO handelt es sich um eine Schalleintrittsöffnung. Die Resiststruktur RS kann beispielsweise durch Drucken oder Jetten aufgebracht werden, in einem bevorzugten Prozess jedoch durch Fotolithografie, beispielsweise durch Laserdirektbelichtung auf einer auflaminierten lichtempfindlichen Folie.

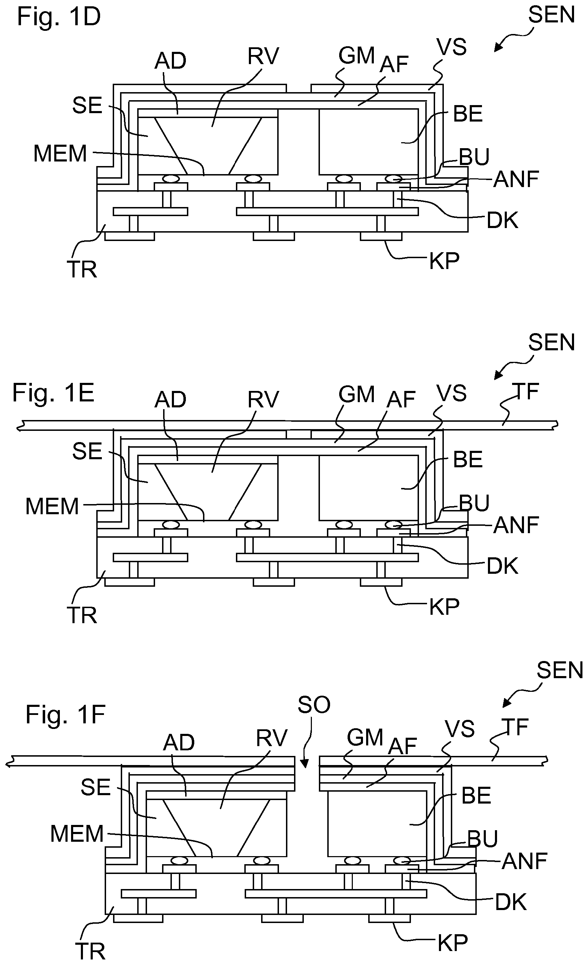

Die Verstärkung der Grundmetallisierung GM kann beispielsweise stromlos oder durch galvanische Abscheidung von Kupfer als Leitschicht und einer weiteren Schicht als Korrosionsschutzschicht erfolgen, wobei die Leitschicht und die weitere Schicht zusammen eine Verstärkerschicht VS ausbilden. Beispielsweise werden ca. 50 µm Cu und einige µm Nickel nacheinander galvanisch über der Grundmetallisierung GM erzeugt. Figur 1D zeigt die Anordnung nach dem galvanischen Abscheiden der Verstärkerschicht VS und nach dem Entfernen der Resiststruktur RS. Eine Öffnung in der Verstärkerschicht VS befindet sich nach dem Entfernen der Resiststruktur RS da, wo die Resiststruktur RS eine galvanische Verstärkung der Grundmetallisierung GM verhindert hat.

Figur 1E zeigt die Anordnung nach einem weiteren Verfahrensschritt. Dabei wird der Sensor SEN auf eine Trägerfolie TF aufgeklebt. Insbesondere wird die dem Träger TR abgewandte Seite des Sensors SEN auf die Trägerfolie TF aufgeklebt.

Die bisher beschriebenen Fertigungsschritte der Anordnung inklusive dem Aufkleben des Sensors SEN auf die Trägerfolie TF können bei unmittelbarem Verbund zahlreicher Sensorelemente auf einem gemeinsamen Trägersubstrat erfolgen. Dabei werden auf dem gemeinsamen Trägersubstrat, das mehrere hundert bis einige tausend Sensorelemente SE und weitere Bauelemente BE aufweist, die Sensorelemente SE und die weiteren Bauelemente BE über eine möglichst große Zahl von Fertigungsschritten im unmittelbaren Verbund behandelt. Nach dem Aufkleben auf die Trägerfolie TF kann eine Vereinzelung der Sensorelemente SE und der weiteren Bauelemente BE erfolgen. Die Vereinzelung kann beispielsweise durch Sägen erfolgen.

Durch die gespannte Trägerfolie TF bleiben die vereinzelten Sensorelemente SE und weiteren Bauelemente BE in einem mittelbaren Verbund zueinander angeordnet. Dementsprechend können auch nach dem Vereinzeln mehrere Sensorelemente SE und weitere Bauelemente BE gemeinsam behandelt werden.

Figur 1F zeigt den Sensor SEN nach der Erzeugung einer Öffnung SO durch die Trägerfolie TF, die Grundmetallisierung GM und die Abdeckfolie AF. Die Öffnung SO kann beispielsweise durch Bohren, insbesondere Laserbohren erzeugt werden. Dabei ist nur die relativ dünne Grundmetallisierung GM, die vorzugsweise aus Kunststoff bestehende Abdeckfolie AF und die Trägerfolie TF zu durchbrechen. Dies gelingt mit relativ geringen Intensitäten und in kontrollierter Weise, so dass eine Beschädigung unterhalb der Öffnung SO gelegener Komponenten des Sensorelements SE erfolgreich verhindert werden kann. Zum Öffnen der Grundmetallisierung GM im Bereich der Öffnung SO sind beispielsweise CO₂-, YAG- oder UV-Laser geeignet.

Die Kontur der vorher erzeugten Dünnstelle kann bei einem Detektionsverfahren zur Bestimmung der Positionierung der Bohrung herangezogen werden. Bei dem Detektionsverfahren kann es sich beispielsweise um eine automatische Bilderkennung handeln. In einem alternativen Verfahren wird die Resiststruktur RS vor ihrer Entfernung zu dem oben erwähnten Detektionsverfahren zur Bestimmung der Positionierung der Bohrung herangezogen.

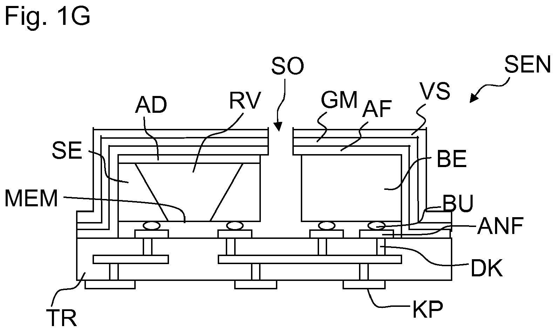

Nach dem Erstellen der Öffnung SO kann ein Funktionstest des Sensors SEN durchgeführt werden. Anschließend wird die Trägerfolie TF entfernt. Figur 1G zeigt den Sensor SEN nach der Entfernung der Trägerfolie TF. Figur 1G zeigt somit den Sensor SEN nach Beendigung des Herstellverfahrens.

Das Verfahren ermöglicht es alternativ sowohl die Öffnung SO des Sensors SEN als auch die elektrischen Kontakte KP des Trägers TR auf der von der Trägerfolie TF bedeckten Seite des Trägers TR anzuordnen. In diesem Fall können die für die Funktionsprüfung erforderlichen elektrischen Kontakte KP mit Hilfe des Lasers freigelegt werden.

Das Vereinzeln könnte auch in einer anderen Verfahrensstufe vorgenommen werden. Wird das Vereinzeln jedoch vor der Funktionsprüfung vorgenommen, so können in der Funktionsprüfung Fehler erkannt werden, die während des Vereinzelns entstehen. Wird das Vereinzeln vor dem Bohren der Öffnung SO durchgeführt, so kann verhindert werden, dass Sägeflüssigkeiten oder Staub die beim Vereinzeln entstehen, durch die Öffnung SO in den Innenraum des Sensors SEN gelangen können.

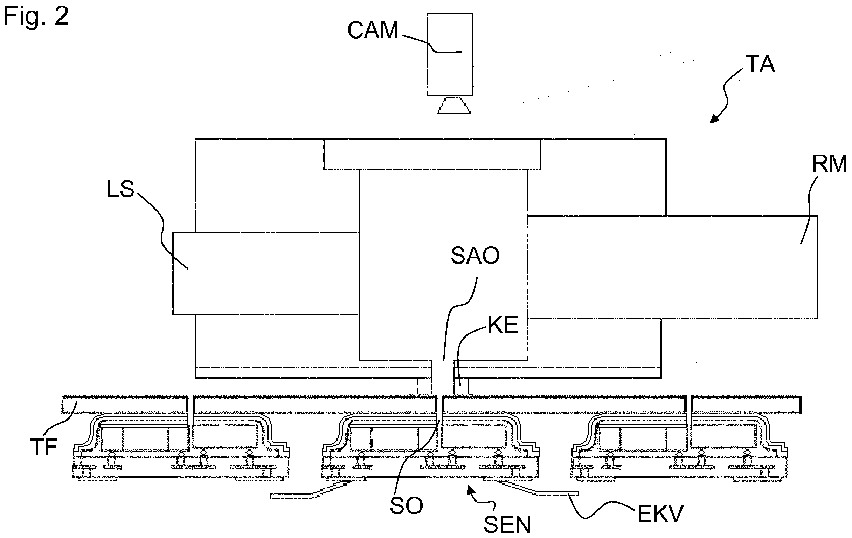

Figur 2 zeigt ein Testverfahren, mit dem die gefertigten Sensoren SEN auf ihre Funktionsfähigkeit getestet werden. Das hier gezeigte Testverfahren wird nach der Vereinzelung und vor dem Abnehmen der Sensoren SEN von der Trägerfolie TF durchgeführt. Die Trägerfolie TF verbindet die Sensoren SEN zu einem mittelbaren Verbund. Für den Funktionstest wird eine Testapparatur TA verwendet, die einen Lautsprecher LS, eine Schallaustrittsöffnung SAO und ein Referenzmikrofon RM aufweist.

Die Testapparatur TA wird über der Öffnung SO des zu testenden Sensors SEN derart justiert, dass die Schallaustrittsöffnung SAO der Testapparatur TA und die Öffnung SO des Sensors SEN übereinanderliegen. Für die Feinjustierung kann eine Kamera CAM eingesetzt werden. Die Schallaustrittsöffnung SAO und die Öffnung SO des Sensors SEN sind akustisch miteinander gekoppelt. Die Ausrichtung des Sensors SEN zur Testapparatur TA erfolgt durch eine Relativbewegung zwischen der Trägerfolie TF und der Testapparatur TA.

Ferner weist die Testapparatur TA eine elektrische Kontaktvorrichtung EKV auf, die eine elektrische Kontaktierung des Sensors ermöglicht. Durch eine Relativbewegung der Testapparatur TA und der auf der Trägerfolie TF angeordneten Sensoren SEN zueinander können mehrere Sensoren SEN nacheinander getestet werden.

Ferner weist die Testapparatur TA eine Dichtstruktur auf, die ein Kopplungselement KE zur akustischen Kopplung des Sensors SEN mit der Testapparatur TA bildet. Die Dichtstruktur umschließt die Schallaustrittsöffnung SO der Testapparatur TA. Das Kopplungselement KE ist aus einem verschleißfreien Material, beispielsweise Metall. Die Trägerfolie TF dichtet den Übergang zwischen dem Kopplungselement KE und der Öffnung SO des Sensors SEN ab. Da die Trägerfolie TF aus einem weichen Material gefertigt ist, das unter Reibung eine Verschleiß-Abnutzung zeigt, werdenauf diese Weise der Sensor SEN und das Kopplungselement KE gegen Verschleiß geschützt.

Alternativ kann der Funktionstest auch derart durchgeführt werden, dass zwischen der Schallaustrittsöffnung SAO und der Öffnung SO des Sensors SO ein Spalt frei bleibt, so dass Testapparatur TA und Sensor SO kein geschlossenes System bilden.

### Bezugszeichenliste

- SEN: - Sensor
- SE: - Sensorelement
- BE: - weiteres Bauelement
- TR: - Träger
- MEM: - Membran
- RV: - Rückvolumen
- AD: - Abdeckung
- AF: - Abdeckfolie
- BU: - Bump
- ANF: - Anschlussfläche
- KP: - Kontaktpad
- DK: - Durchkontaktierung
- GM: - Grundmetallisierung
- SO: - Öffnung
- RS: - Resiststruktur
- VS: - Verstärker-Schicht
- TF: - Trägerfolie
- TA: - Testapperatur
- LS: - Lautsprecher
- SAO: - Schallaustrittsöffnung
- RM: - Referenzmikrofon
- CAM: - Kamera
- EKV: - elektrische Kontaktvorrichtung
- KE: - Kopplungselement

## Patentansprüche

1. Verfahren zur Herstellung eines Sensors (SEN), aufweisend die Schritte:
- Anordnen eines Sensorelements (SE) auf einem Träger (TR)
- Anordnen einer Abdeckung (AF) auf dem Sensorelement (SE), wobei das Sensorelement (SE) zwischen der Abdeckung (AF) und dem Träger (TR) eingeschlossen wird,
- Aufkleben einer Trägerfolie (TF) auf die Abdeckung (AF),
- Erzeugen einer Öffnung (SO) in der Trägerfolie (TF) und der Abdeckung (AF), wobei die Öffnungen (SO) in der Trägerfolie (TF) und der Abdeckung (AF) zumindest teilweise überlappen,
- Entfernen der Trägerfolie vom Sensor.

2. Verfahren gemäß Anspruch 1,
bei dem die Öffnung (SO) in der Trägerfolie (TF) und der Abdeckung (AF) nach dem Aufkleben der Trägerfolie (TF) erzeugt wird.

3. Verfahren gemäß Anspruch 1 oder 2,
bei dem die Öffnung (SO) in der Trägerfolie (TF) und in der Abdeckung (AF) in einem gemeinsamen Verfahrensschritt erzeugt werden.

4. Verfahren gemäß einem der vorherigen Ansprüche,
bei dem die Öffnung (SO) der Trägerfolie (TF) und der Abdeckung (AF) deckungsgleich sind.

5. Verfahren gemäß Anspruch 1,
bei dem je eine Öffnung (SO) in der Trägerfolie (TF) und in der Abdeckung (AF) vor dem Aufkleben der Trägerfolie (TF) erzeugt werden und
bei dem das Sensorelement (SE) beim Aufkleben derart positioniert wird, das sich die Öffnungen (SO) der Trägerfolie (TF) und der Abdeckung (AF) zumindest teilweise überlappen.

6. Verfahren gemäß einem der vorherigen Ansprüche,
bei dem eine Vielzahl von Sensorelementen (SE) auf einem Trägersubstrat angeordnet werden und
bei dem eine Abdeckung (AF) derart auf den Sensorelementen (SEN) angeordnet wird, dass die Sensorelemente (SEN) jeweils zwischen dem Trägersubstrat und der Abdeckung (AF) eingeschlossen werden,
bei dem eine Trägerfolie (TF) auf die Abdeckung (AF) geklebt wird, und
bei dem die Sensorelemente (SEN) nach dem Aufkleben vereinzelt werden.

7. Verfahren gemäß Anspruch 1, bei dem vor dem Entfernen der Trägerfolie (TF) mittels einer Testapparatur (TA)ein Funktionstest des Sensors (SEN) durchgeführt wird, wobei der Sensor (SEN) durch eine Relativbewegung der Trägerfolie (TF) und der Testapparatur (TA) relativ zu der Testapparatur (TA) ausgerichtet wird.

8. Verfahren gemäß einem der vorherigen Ansprüche, bei dem die Trägerfolie (TF) während des Funktionstests eine Dichtung zwischen dem Sensor (SEN) und der Testapparatur (TA) bildet.

9. Verfahren gemäß einem der vorherigen Ansprüche, bei dem die Öffnung (SO) in der Trägerfolie (TF) und der Abdeckung (AF) durch Bohren erzeugt wird.

10. Verfahren gemäß einem der vorherigen Ansprüche, bei dem die Abdeckung (AF) eine Schichtdicke aufweist, die im Bereich der zu erzeugenden Öffnung (SO) bereits beim Aufbringen der Abdeckung (AF) dünner ist als in einem anderen Bereich oder die in diesem Bereich nachträglich reduziert wird.

11. Verfahren gemäß Anspruch 9, bei dem eine Grundmetallisierung (GM) über dem Sensorelement (SE) aufgebracht wird,
bei dem eine Resiststruktur (RS) im Bereich der zu erzeugenden Öffnung (SO) aufgebracht wird,
bei dem über der Grundmetallisierung (GM) eine Verstärkungsschicht (VS) erzeugt wird, wobei der von der Resiststruktur (RS) bedeckte Bereich der Grundmetallisierung (GM) frei von der Verstärkungsschicht (VS) bleibt.

12. Verfahren gemäß Anspruch 10 oder 11, bei dem der dünnere Bereich der Abdeckung (AF) in einem Detektionsverfahren erkannt wird und zur Bestimmung der Position, an der die Öffnung (SO) erzeugt wird, benutzt wird.

13. Verfahren gemäß einem der vorherigen Ansprüche, bei dem der Sensor (SEN) auf einer der Trägerfolie (TF) gegenüberliegenden Seite Mittel zur elektrischen Kontaktierung (KP) aufweist.

14. Verfahren gemäß einem der Ansprüche 1-12, bei dem der Sensor (SEN) Mittel zur elektrischen Kontaktierung (KP) aufweist, die auf der Seite der Trägerfolie (TF) angeordnet sind.

15. Verfahren gemäß Anspruch 14, bei dem die Trägerfolie (TF) von den Mitteln zur elektrischen Kontaktierung (KP) oder von der Testapparatur (TA) durchstochen wird oder bei dem die Trägerfolie (TF) in den Bereichen entfernt wird, in denen die Mittel zur elektrischen Kontaktierung (KP) angeordnet sind.

16. Verfahren gemäß einem der vorherigen Ansprüche, bei dem das Sensorelement (SE) ein Wandlerelement ist, das Schallwellen in elektrische Signal umwandelt.

## Claims

1. Method for producing a sensor (SEN), comprising the following steps:
- arranging a sensor element (SE) on a carrier (TR),
- arranging a cover (AF) on the sensor element (SE), wherein the sensor element (SE) is enclosed between the cover (AF) and the carrier (TR),
- adhesively bonding a carrier film (TF) onto the cover (AF),
- producing an opening (SO) in the carrier film (TF) and the cover (AF), wherein the openings (SO) in the carrier film (TF) and the cover (AF) at least partly overlap,
- removing the carrier film from the sensor.

2. Method according to Claim 1,
wherein the opening (SO) in the carrier film (TF) and the cover (AF) is produced after the process of adhesively bonding the carrier film (TF).

3. Method according to Claim 1 or 2,
wherein the openings (SO) in the carrier film (TF) and in the cover (AF) are produced in a common method step.

4. Method according to any of the preceding claims,
wherein the openings (SO) in the carrier film (TF) and the cover (AF) are congruent.

5. Method according to Claim 1,
wherein respective openings (SO) in the carrier film (TF) and in the cover (AF) are produced before the process of adhesively bonding the carrier film (TF), and
wherein the sensor element (SE) is positioned during the adhesive-bonding process in such a way that the openings (SO) in the carrier film (TF) and the cover (AF) at least partly overlap.

6. Method according to any of the preceding claims,
wherein a multiplicity of sensor elements (SE) are arranged on a carrier substrate, and
wherein a cover (AF) is arranged on the sensor elements (SEN) in such a way that the sensor elements (SEN) are enclosed in each case between the carrier substrate and the cover (AF),
wherein a carrier film (TF) is adhesively bonded onto the cover (AF), and
wherein the sensor elements (SEN) are singulated after the adhesive-bonding process.

7. Method according to Claim 1,
wherein a functional test of the sensor (SEN) is carried out by means of a test apparatus (TA) before the carrier film (TF) is removed, wherein the sensor (SEN) is aligned relative to the test apparatus (TA) by a relative movement of the carrier film (TF) and the test apparatus (TA) .

8. Method according to any of the preceding claims,
wherein the carrier film (TF) forms a seal between the sensor (SEN) and the test apparatus (TA) during the functional test.

9. Method according to any of the preceding claims,
wherein the opening (SO) in the carrier film (TF) and the cover (AF) is produced by drilling.

10. Method according to any of the preceding claims,
wherein the cover (AF) has a layer thickness which, in the region of the opening (SO) to be produced, is already thinner than in a different region when the cover (AF) is applied, or which is subsequently reduced in this region.

11. Method according to Claim 9,
wherein a base metalization (GM) is applied above the sensor element (SE),
wherein a resist structure (RS) is applied in the region of the opening (SO) to be produced,
wherein a reinforcement layer (VS) is produced above the base metalization (GM), wherein that region of the base metalization (GM) which is covered by the resist structure (RS) remains free of the reinforcement layer (VS) .

12. Method according to Claim 10 or 11,
wherein the thinner region of the cover (AF) is identified in a detection method and is used for determining the position at which the opening (SO) is produced.

13. Method according to any of the preceding claims,
wherein the sensor (SEN) has means for electrical contact-making (KP) on an opposite side relative to the carrier film (TF).

14. Method according to any of Claims 1-12,
wherein the sensor (SEN) has means for electrical contact-making (KP) which are arranged on the side of the carrier film (TF).

15. Method according to Claim 14,
wherein the carrier film (TF) is perforated by the means for electrical contact-making (KP) or by the test apparatus (TA), or wherein the carrier film (TF) is removed in the regions in which the means for electrical contact-making (KP) are arranged.

16. Method according to any of the preceding claims,
wherein the sensor element (SE) is a transducer element that converts sound waves into electrical signal.

## Revendications

1. Procédé de fabrication d'un capteur (SEN), comprenant les étapes consistant à :
- agencer un élément de détection (SE) sur un support (TR)
- agencer un élément de recouvrement (AF) sur l'élément de détection (SE), dans lequel l'élément de détection (SE) est logé entre l'élément de recouvrement (AF) et le support (TR),
- coller une feuille de support (TF) sur l'élément de recouvrement (AF),
- créer une ouverture (SO) dans la feuille support (TF) et l'élément de recouvrement (AF), dans lequel les ouvertures (SO) de la feuille de support (TF) et de l'élément de recouvrement (AF) se chevauchent au moins partiellement,
- retirer la feuille de support du capteur.

2. Procédé selon la revendication 1, dans lequel l'ouverture (SO) de la feuille de support (TF) et de l'élément de recouvrement (AF) est créée après le collage de la feuille de support (TF).

3. Procédé selon la revendication 1 ou 2, dans lequel les ouvertures (SO) de la feuille de support (TF) et de l'élément de recouvrement (AF) sont créées lors d'une étape de procédé commune.

4. Procédé selon l'une quelconque des revendications précédentes, dans lequel les ouvertures (SO) de la feuille de support (TF) et de l'élément de recouvrement (AF) coïncident l'une avec l'autre.

5. Procédé selon la revendication 1,
dans lequel une ouverture (SO) est créée dans la feuille de support (TF) et dans l'élément de recouvrement (AF) avant de coller la feuille de support (TF) et
dans lequel l'élément de détection (SE) est positionné, lors du collage, de manière à ce que les ouvertures (SO) de la feuille de support (TF) et de l'élément de recouvrement (AF) se chevauchent au moins partiellement.

6. Procédé selon l'une quelconque des revendications précédentes, dans lequel une pluralité d'éléments de détection (SE) sont disposés sur un substrat et dans lequel un élément de recouvrement (AF) est disposé sur les éléments de détection (SEN) de manière à ce que les éléments de détection (SEN) soient chacun enserrés entre le substrat et l'élément de recouvrement (AF), dans lequel une feuille de support (TF) est collée sur l'élément de recouvrement (AF) et les éléments de détection (SEN) sont séparés après le collage.

7. Procédé selon la revendication 1, dans lequel un test de fonctionnement du capteur (SEN) est effectué au moyen d'un appareil de test (TA) avant d'enlever la feuille support (TF), dans lequel le capteur (SEN) est aligné par rapport à l'appareil de test (TA) par un mouvement relatif de la feuille de support (TF) et de l'appareil de test (TA).

8. Procédé selon l'une quelconque des revendications précédentes, dans lequel la feuille de support (TF) forme un joint d'étanchéité entre le capteur (SEN) et l'appareil de test (TA) pendant l'essai de fonctionnement.

9. Procédé selon l'un quelconque des revendications précédentes, dans lequel les ouvertures (SO) de la feuille de support (TF) et de l'élément de recouvrement (AF) sont réalisées par percement.

10. Procédé selon l'une quelconque des revendications précédentes, dans lequel l'élément de recouvrement (AF) présente une épaisseur de couche qui est plus faible dans la région de l'ouverture (SO) à produire que dans une autre région lorsque l'élément de recouvrement (AF) a déjà été appliqué, ou qui est ultérieurement réduite dans ladite région.

11. Procédé selon la revendication 9, dans lequel une métallisation de base (GM) est appliquée sur l'élément de détection (SE), dans lequel une structure de réserve (RS) est appliquée dans la région de l'ouverture (SO) à produire, dans lequel une couche de renforcement (VS) est produite sur la métallisation de base (GM), dans lequel la région de la métallisation de base (GM) recouverte par la structure de réserve (RS) reste exempte de la couche de renforcement (VS).

12. Procédé selon la revendication 10 ou 11, dans lequel la partie plus mince de l'élément de recouvrement (AF) est détectée par un procédé de détection et est utilisée pour déterminer la position à laquelle l'ouverture (SO) est produite.

13. Procédé selon l'une quelconque des revendications précédentes, dans lequel le capteur (SEN) comporte des moyens d'établissement de contact électrique (KP) sur un côté opposé à la feuille de support (TF).

14. Procédé selon l'une quelconque des revendications 1 à 12, dans lequel le capteur (SEN) comporte des moyens d'établissement de contact électrique (KP) disposés sur le côté de la feuille de support (TF).

15. Procédé selon la revendication 14, dans lequel la feuille de support (TF) est percée par les moyens de contact électrique (KP) ou par l'appareil de test (TA) ou dans lequel la feuille de support (TF) est enlevée dans les zones dans lesquelles sont disposés les moyens de contact électrique (KP).

16. Procédé selon l'une quelconque des revendications précédentes, dans lequel l'élément de détection (SE) est un élément transducteur qui convertit des ondes sonores en signal électrique.
